# EUROPEAN PATENT APPLICATION

(11) **EP 1 205 950 A1**
(43) Date of publication of application: **15.05.2002**
(21) Application number: 01000589.0
(22) Date of filing: 02.11.2001
(51) Int. Cl.: H01F 5/04

(54) **Coil holder**

(30) Priority: 14.11.2000 FI 20002492
(71) Applicant: TEKNOWARE OY, 15200 Lahti (FI)
(72) Inventor: Kataja, Jari, 15200, Lahti (FI)
(74) Representative: Peltonen, Antti Sakari

(57) **Abstract**

A coil holder intended to be embedded through an opening in a circuit board (6) or the like, the coil holder comprising a frame part (1) arranged to receive one or more coil sections. The coil holder also comprises one or more connectors (2) including a first and a second soldering pin end (3, 4), whereby the first soldering pin end (3) is arranged to be connected to a coil section to be wound onto the frame part (1) of the coil holder and the second soldering pin end (4) is arranged to be connected to the circuit board (6).

## Description

### BACKGROUND OF THE INVENTION

The invention relates to a coil holder intended to be embedded through an opening in a circuit board or the like, the coil holder comprising a frame part arranged to receive one or more coil sections.

Coil holders are generally used for forming inductive electronic components such as transformers and chokes. A coil holder is made of insulating material, and a winding can be appropriately placed to surround the frame part. Coil holders are manufactured as separate components without windings, thus allowing each manufacturer to implement the accurately determined properties for the manufactured components by providing the winding himself.

The winding surrounding the frame part of the coil holder is made before a component is attached to the circuit board or the like. Several alternative ways are used to fasten the coil holder to the circuit board. The frame can be entirely fastened onto the surface of the board using different locks or joints.

Another alternative for fastening the wound coil holder is to partly embed the frame through the circuit board. On account of such an embedding, space can be saved in the elevation of the board, as the coil is generally the highest one of the components on the circuit board. The embedded coil holders are also fastened as shown above using matching sections or the like.

As to the embedded coil holders, in the previous implementations the ends of the windings formed to surround the coil holder are fastened to the circuit board by setting separate threads by hand at the appropriate places while the machine carries out the actual soldering. Setting the threads by hand is extremely laborious and requires considerable accuracy. The manufacturing process also decelerates significantly as the machines handle the rest of the composing and tinning operations.

### BRIEF DESCRIPTION OF THE INVENTION

It is an object of the invention to provide a coil holder that avoids the above drawbacks and enables to perform the winding and to embed the coil holder in a simpler and more reliable manner than previously. This object is achieved with a coil holder of the invention, characterized in that the coil holder also comprises one or more connectors including a first and a second soldering pin end, whereby the first soldering pin end is arranged to be connected to a coil section to be wound onto the frame part of the coil holder and the second soldering pin end is arranged to be connected to the circuit board.

The invention is based on the idea that connectors are connected to the coil holder, through which the winding to be wound onto the frame is connected to an electric circuit of the circuit board or the like. This is implemented in such a manner that the first soldering pin ends of the connectors are connected to the windings, and the second soldering pin ends of the connectors are connected to the circuit board.

An advantage provided by the invention is that it becomes significantly faster to perform the winding and to connect the wound component to the circuit board. In addition, the use of the coil holder of the invention allows to electrically fasten the component reliably to the circuit board. As the coil holder can also be embedded through the circuit board, the height of the circuit board is simultaneously reduced in comparison with the previous one.

### BRIEF DESCRIPTION OF THE DRAWINGS

In the following the invention is described in greater detail by means of the preferred embodiments with reference to the accompanying drawings, in which:

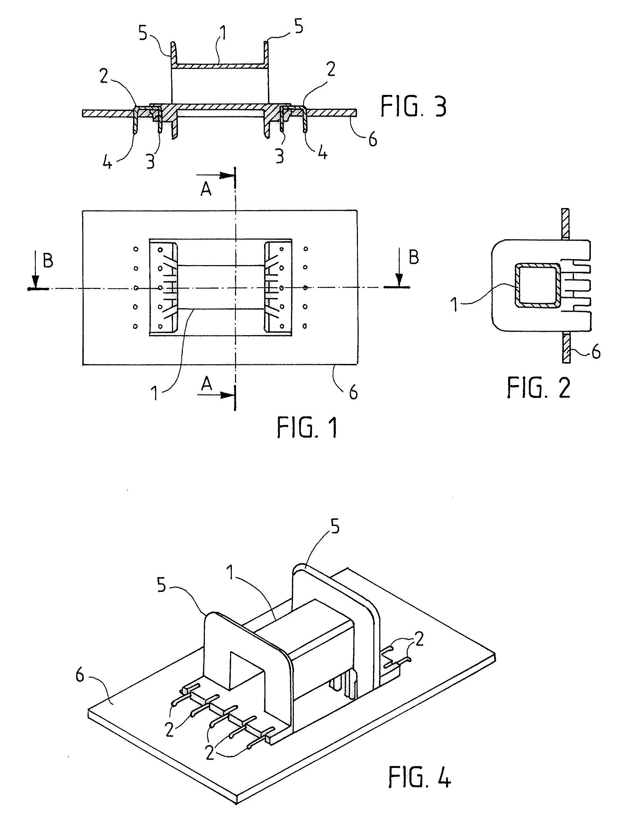

Figure 1 shows a coil holder of the invention fastened to a circuit board seen from below,
Figure 2 is a cross-section showing position A-A of the coil holder in Figure 1,
Figure 3 is a cross-section showing position B-B of the coil holder in Figure 1,
Figure 4 is a perspective view showing the coil holder of the invention.

### DETAILED DESCRIPTION OF THE INVENTION

The Figures show a coil holder of the invention without windings connected to a circuit board 6. In accordance with the invention the coil holder comprises a frame part 1 arranged to receive a winding in order to achieve a desired electrical effect. The cross-section of the frame part resembles a square in the preferred embodiments shown in the Figures, however, in such a manner that the bevels thereof are rounded. The shape of the frame part shown in cross-section can nevertheless also resemble a circle or any other form. In the preferred embodiment shown, the frame part is hollow and thus enables to place the core of the coil within the frame part. The core of the coil is made of ferrite, iron or of another similar ferromagnetic material. The coil holder can be provided with a transformer, a choke or another inductive component.

The coil holder of the invention also comprises one or more connectors 2, a first soldering pin end 3 thereof being arranged to be connected to a coil section to be wound onto the frame part of the coil holder and a second soldering pin end 4 to the circuit board. The winding is formed onto the coil holders of thin winding wire, typically using a separate winding machine that forms an appropriate and even coil. The winding machine can also be used to automatically connect the winding overhangs to the first soldering pin end 3 of the connector of the coil holder. The winding machine wraps the winding overhang reliably around the first ends 3 of the connectors. The second soldering pin ends 4 of the connectors remain free during the winding process.

After the winding, a finishing touch is put upon the coil holder of the invention by soldering the winding overhang to the first ends of the connectors. The soldering can be carried out automatically by embedding said pins into molten tin. Hence, a finished component provided with connectors, or pins, is formed that can be embedded through the circuit board and connected from the pins thereof to the electric circuits of the circuit board 6.

The second ends 4 of the connectors 2 are arranged to be connected to the electric circuits of the circuit board. The connectors 2 then form an electric wire for the coil holder between the formed winding and the electric circuits. In accordance with a preferred embodiment of the invention the shape of the connectors resemble the letter U and they are connected to the coil holder from the first end 3 thereof. The shape of the connector causes both the connector ends to point downwards from the bottom part of the coil holder. Consequently, during the winding, the winding overhang can easily be wound around the first end 3, or the pin, of the connector. The connectors of the coil holder are formed of substantially stiff metal filament that conducts electricity.

In addition to the frame part 1, the coil holder of the invention includes end parts 5, which are wider than the frame part, placed at both ends of the frame part. The end parts 5 assure that the winding is held in position around the frame part 1. When the coil holder of the invention is embedded through a circuit board, a hole must be formed into the circuit board, the size of the hole substantially corresponding with the outside measures of the coil holder. The coil holder is pushed through the circuit board substantially at such a depth that the lower part of the frame part reaches the level of the circuit board, as shown in the Figure.

The base part of the U-shaped connectors 2, i.e. the part of the connector that connects the first and the second ends, or the pins, of the connector to one another is placed substantially at the same level as the lower part of the coil holder. Mounted in this way, and as the ends 4 of the second soldering pins of the connectors are pressed through the circuit board, the lowest positions of the end parts 5 in the coil holder remain beneath the circuit board. Owing to the embedded coil holder the height of the connection to be made onto the circuit board decreases considerably on several occasions, while the coil remains the highest component. Some open space must be left beneath the circuit board on all occasions, as the pins of several components pass through the board, and tinning is carried out below the board. Furthermore, free space must be provided beneath the board to cool the circuit board. Thus, the part of the embedded coil holder to be placed beneath the circuit board reduces the total height of the assembly.

The coil holder of the invention is fastened to the circuit board by tinning, and a standard mechanical composing process can be used to place the coil holder in position. When placing the coil holder onto the circuit board, the coil holder is placed into a carefully arranged opening of the circuit board to reliably rest upon a flange-like edge. During tinning the second ends 4 of the connectors in the coil holder are electrically connected to the circuit of the circuit board. In this way, a reliable electrical contact can be formed between the windings of the coil holder and the electric circuit of the circuit board. The size of the coil holder structure is determined in accordance with the size of the required electric component.

The connectors can also be shaped so as to comprise only a 90-degree angle, in which case the second end of the connector points away from the coil holder. The first end 3 then points straight downward and thus allows to connect the winding to the connector. A coil holder comprising such connectors can be connected to the circuit board using surface mounting technique, tinning the second ends of the connectors parallel to the circuit board onto the upper or lower surface of the circuit board, depending on the side from which the component is brought to the circuit board.

It is obvious for those skilled in the art that as technology progresses the basic idea of the invention can be implemented in various ways. The invention and the preferred embodiments thereof are not restricted to the above examples but may vary within the scope of the claims.

## Claims

1. A coil holder intended to be embedded through an opening in a circuit board (6) or the like, the coil holder comprising a frame part (1) arranged to receive one or more coil sections, **characterized in that** the coil holder to be placed into the opening of the circuit board also comprises one or more connectors (2) including a first and a second soldering pin end (3, 4), whereby the first soldering pin end (3) is arranged to be connected to a coil section to be wound onto the frame part (1) of the coil holder and the second soldering pin end (4) is arranged to be connected to the circuit board (6).

2. A coil holder as claimed in claim 1, **characterized in that** the connectors (2) are U-shaped and attached from the first soldering pin ends (3) to the coil holder.

3. A coil holder as claimed in claim 1 or 2, **characterized in that** the second soldering pin ends (4) of the connectors (2) are arranged to be pressed through the circuit board (6) or the like, thus allowing to tin the component formed on the coil holder to form a part of the electric circuit.
